(19) **Europäisches Patentamt / European Patent Office / Office européen des brevets**

(11) **EP 3 583 241 B1**

(12) **FASCICULE DE BREVET EUROPEEN**

(45) Date de publication et mention
de la délivrance du brevet:
**23.12.2020 Bulletin 2020/52**

(21) Numéro de dépôt: **18706813.5**

(22) Date de dépôt: **12.02.2018**

(51) Int Cl.:
*C23C 14/00* (2006.01)  *C23C 14/48* (2006.01)
*C30B 29/20* (2006.01)  *C30B 33/04* (2006.01)
*G06F 3/044* (2006.01)  *C30B 31/22* (2006.01)
*H04M 1/02* (2006.01)  *H04M 19/04* (2006.01)

(86) Numéro de dépôt international:
**PCT/FR2018/050332**

(87) Numéro de publication internationale:
**WO 2018/150130 (23.08.2018 Gazette 2018/34)**

(54) **PROCÉDÉ DE TRAITEMENT PAR UN FAISCEAU D'IONS POUR PRODUIRE UN SAPHIR ANTIREFLET A HAUTE TRANSMITTANCE RÉSISTANT A LA RAYURE**

IONENSTRAHLBEHANDLUNGSVERFAHREN ZUR HERSTELLUNG EINES KRATZFESTEN HOCHDURCHLÄSSIGEN ANTIREFLEKTIVEN SAPHIRS

ION BEAM TREATMENT PROCESS FOR PRODUCING A SCRATCH-RESISTANT HIGH-TRANSMITTANCE ANTIREFLECTIVE SAPPHIRE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.02.2017 FR 1770134**

(43) Date de publication de la demande:
**25.12.2019 Bulletin 2019/52**

(73) Titulaire: **Ionics France**
**14200 Herouville-Saint-Clair (FR)**

(72) Inventeurs:
• **BUSARDO, Denis**
**14510 Gonneville Sur Mer (FR)**
• **GUERNALEC, Frédéric**
**35340 Liffre (FR)**

(74) Mandataire: **Plasseraud IP**
**66, rue de la Chaussée d'Antin**
**75440 Paris Cedex 09 (FR)**

(56) Documents cités:
**WO-A1-2015/176850    FR-A1- 3 027 120**

**Description**

L'invention a pour objet de traiter par implantation ionique une pièce saphir, pour obtenir un traitement antireflet (AR) à haute transmittance résistant à la rayure. On entend par saphir un matériau comprenant au moins 98% en poids d'oxyde d'aluminium, comme par exemple au moins 99% en poids d'oxyde d'aluminium, comme par exemple au moins 99,9% en poids d'oxyde d'aluminium.

Un matériau saphir peut être constitué d'un ou de plusieurs monocristaux de corindon. Sa nature peut donc être polycristalline. Selon un mode de réalisation de la présente invention, un matériau saphir est une partie monocristalline de corindon. Typiquement les substrats en matériau saphir de la présente invention se présentent selon les applications visées sous forme de feuille plate ou sous forme de disques plus ou moins arrondis et plus ou moins bombés, pour les montres et les lentilles par exemple. Sans que cela n'implique une quelconque limitation à la présente invention les épaisseurs des substrats traités n'excèdent le plus souvent pas 2 mm.

Un matériau saphir peut être naturel ou synthétique; Selon un mode de réalisation, un matériau saphir de la présente invention est un matériau saphir synthétique. On entendra dans ce qui suit par traitement antireflet à haute transmittance un traitement antireflet (traitement AR) pour lequel on augmente la transmittance d'un substrat en saphir de 86%, mesurée à une longueur d'onde de 530nm, à une transmittance supérieure ou égale à 91% pour un traitement sur une seule face du matériau et supérieure ou égale à 96% pour un traitement sur les deux faces. Cela se traduit pour une pièce saphir par un traitement appliqué sur une des deux faces de celui-ci, de manière à ce que la réflectance Y (%) de la face traitée devienne inférieure ou égale à 9% à longueur d'onde de 530 nm. On entendra dans ce qui suit par réflectance Y exprimé en %, la réflectance mesurée à une longueur d'onde de 530 nm mesurée sur la face traitée. Au-delà d'une transmittance de 96%, autrement dit pour $Y \leq 9\%$ sur un substrat en saphir typique, il est en effet couramment admis que l'œil humain perçoit très difficilement des différences de transmittance (par exemple entre une transmittance de 97,5% et 98,5%).

Dans le cadre de la présente invention on entend par résistance aux rayures, la capacité d'un matériau en saphir ayant subi un traitement antireflet à résister à la formation de rayures lors de son utilisation. Ainsi par exemple, un écran tactile subit des frottements répétés lorsqu'il est sorti et remis dans une poche, une lentille optique lors de son nettoyage et un verre de montre au contact permanent d'un revers de manche. Il existe un moyen simple pour évaluer cette résistance aux rayures basée sur l'échelle de dureté de Mohs. Comme c'est une échelle ordinale, on doit procéder par comparaison (capacité d'un matériau à rayer l'autre sous faible charge) avec un matériau dont on connaît déjà la dureté. Cette échelle n'est ni linéaire, ni logarithmique. Cette échelle est donnée ci-dessous (voir Tab.1).

Il y a des revêtements antireflet obtenus par pulvérisation cathodique, souvent assistée par magnétron, sur des matériaux en saphir (AR PVD) qui atteignent une dureté de Mohs sensiblement proche voire égale à 7 Mohs, 7 Mohs, dureté comparable voire supérieure à celle du quartz, étant souvent considéré comme le minimum acceptable dans beaucoup d'applications, notamment en horlogerie(). Ces AR VPD atteignent aussi des hautes transmittances, mais ce procédé requiert un contrôle très précis du dépôt de nombreuses couches minces de différents matériaux, ce qui est compliqué et couteux.

Tab 1.

| Dureté | Matériau |
|---|---|
| 1 | Talc, friable sous l'ongle |
| 2 | Gypse, rayable avec l'ongle |
| 3 | Calcite, rayable avec une pièce en cuivre |
| 4 | Fluorine, rayable (facilement) avec un couteau |
| 5 | Apatite, rayable au couteau |
| 6 | Orthose, rayable à la lime, par le sable |
| 7 | Quartz, raye le verre |
| 8 | Topaze, rayable par le carbure de tungstène |
| 9<br>10 | Corindon (saphir), rayable au carbure de silicium<br>Diamant, rayable avec un autre diamant |

Une autre méthode qui convient pour évaluer la griffabilité des matériaux en saphir traités est le rayage à charge progressive (progressive load scratch test - PLST) qui correspond à l'application d'une charge continue et progressive durant le déplacement de l'échantillon sous un indenteur.

Le brevet WO 2015176850 A1 **« Single- and/or multicharged gas ion beam treatment method for producing an anti-glare sapphire material »**, déposé par les inventeurs, décrit les conditions de traitement AR d'un saphir par implantation ionique permettant d'atteindre pour un traitement double face des transmittances très élevées pouvant atteindre 99,5% (soit un gain de plus ou moins 14% en les comparant aux transmittances de référence d'un saphir brut égal à 85,6% pour verre saphir de référence).

De même FR3027120 traite aussi de l'implantation ionique dans un saphir.

Des essais complémentaires de dureté de type Mohs effectués par les inventeurs sur ce traitement AR obtenu par implantation ionique, ont permis de révéler qu'il existait une plage de dose étroite (située entre 5,5 et $8,5 \times 10^{16}$ ions/cm2), dans laquelle l'augmentation de la transmittance s'accompagnait d'une réduction très rapide de la dureté de Mohs, et de la résistance à l'abrasion qui lui est associée.

Les inventeurs donnent ci-dessous un tableau (Tab. 2) résumant les résultats expérimentaux qui leur ont permis d'identifier précisément cette corrélation étroite entre réflectance Y de la face traitée et la dureté de Mohs de la face traitée, selon une dose d'ions d'azote implantées à une tension d'accélération de 20 kV. La dureté Mohs suite au traitement AR a été évaluée en utilisant un couteau en céramique calibré pour avoir une dureté Mohs 7 et un fil d'une largeur d'environ 20 $\mu$m. On fait glisser ce couteau en céramique sur la surface AR avec une faible charge de 50 g puis en observe sous lumière rasante (80° par rapport à la normale) l'existence ou non de rayure(s) observable(s) à l'œil nu. Dans ce qui suit lorsque nous parlerons de dureté de Mohs, nous ferons référence à ce protocole d'essai que nous venons de décrire. On rappelle que la dureté de Mohs supérieure ou égale à 7 a été retenue par l'invention comme une dureté acceptable au regard des duretés des AR PVD sensiblement proche voire égale à 7 Mohs.

Tab. 2

| Tension d'accélération (kV) | Dose ($10^{16}$ ions/cm2) | Y% (à 530 nm) | Rayure sous spot rasant avec couteau céramique Mohs 7 | Dureté Mohs |
|---|---|---|---|---|
| 20 | 6,75 | 9,9 | non | >7 |
| | 7,00 | 10,0 | non | >7 |
| | 7,25 | 9,8 | non | >7 |
| | 7,50 | 9,7 | limite | 7 |
| | 7,75 | 9,6 | oui | <7 |
| | 8,00 | 9,5 | oui | <7 |
| | 8,25 | 9,6 | oui | <7 |
| | 8,50 | 9,5 | oui | <7 |

On constate qu'autour de la dose $7,50 \times 10^{16}$ ions/cm2 la dureté de Mohs bascule rapidement entre $7,25 \times 10^{16}$ et $7,75 \times 10^{16}$ ions/cm2 de >7 à <7 Mohs dans le sens des doses croissantes et que la réflectance Y d'une face traitée demeure toujours supérieure à 9%. A priori, il semble compte tenu de ces résultats, qu'il soit impossible de concilier pour un traitement AR par implantation ionique une faible valeur de réflectance (Y inférieur ou égale à 9%) et une dureté de Mohs suffisante (de préférence supérieure ou égale à 7).

A première vue cette difficulté technique à concilier dureté de Mohs supérieure ou égale à 7 et réflectance Y inférieure ou égale à 9% pour atteindre une haute transmittance, handicape voire invalide le champ de substitution du procédé de l'implantation ionique aux AR PVD connus pour avoir des réflectances Y% < 9% et des duretés Mohs proches de 7, ne serait-ce que pour la face externe de la pièce saphir, soumise aux contraintes d'usage les plus fortes.

L'invention a pour but de remédier aux inconvénients et problèmes techniques exposés précédemment.

L'invention propose un procédé de traitement AR par implantation ionique pour une pièce en saphir caractérisée par une réflectance Y de la face traitée inférieure ou égale à 9%, en conservant sur ladite face traitée une dureté supérieure ou égale à 7 Mohs.

L'invention propose un procédé de traitement AR par implantation ionique caractérisé en ce que l'on forme des nanocavités dans l'épaisseur traitée et en ce que l'on contrôle pour une même dose d'ions implantés avec une même tension d'accélération, la taille des nanocavités, en adaptant la vitesse de déplacement du faisceau autrement dit les conditions thermiques locales (in situ) et transitoires lors du passage du faisceau. On appelle par nanocavités des pores dont la taille varie du nm à quelques dizaines de nm, c'est-à-dire comprise entre 1 nm et 100nm.

L'invention propose un traitement AR par implantation ionique caractérisé par la création dans l'épaisseur traitée de nanocavités d'une taille inférieure ou égale à une taille maximale pour pouvoir répondre aux contraintes optiques (Y inférieure ou égale à 9%) et mécaniques (dureté supérieure ou égale à 7 Mohs) visées par l'invention.

L'invention a pour but d'offrir une méthode de traitement de pièces en saphir peu onéreuse et permettant de traiter des surfaces répondant aux besoins de nombreuses applications. Parmi ces applications on citera en particulier: les écrans tactiles, les lentilles d'un dispositif optique, les verres de montre.

La pièce en saphir et le faisceau d'un mélange d'ions mono- et multichargés d'un gazse déplacent l'un par rapport à l'autre à une vitesse, $V_D$. Selon un mode de réalisation, la pièce en saphir est déplacée sous le faisceau d'un mélange d'ions mono- et multichargés d'un gazselon une pluralité, N, de passages à la vitesse $V_D$. Chaque passage est caractérisé par une série d'aller-retours d'amplitudes données, séparés parallèlement les uns des autres par un pas d'avancement correspondant à une fraction du diamètre du faisceau pour garantir l'homogénéité du traitement. Lorsque les paramètres faisceau et cinématiques sont fixés, la dose reçue exprimée en nombre d'ions par unité de surface est proportionnelle au nombre de passage(s) effectué(s). Les modes de déplacement de la pièce de saphir par rapport au faisceau d'ions peuvent cependant varier.

L'invention propose un procédé de traitement AR de pièce saphir selon la revendication 1, caractérisé en ce qu'il comprend un bombardement de la pièce saphir par le faisceau d'un mélange d'ions mono- et multichargés d'un gaz produits par une source à résonance cyclotronique électronique (RCE) où:

- on choisit la dose d'ions d'un gaz mono- et multichargés implantés par unité de surface dans une plage comprise entre $10^{16}$ et $3 \times 10^{17}$ ions/$cm^2$;

- on choisit la tension d'accélération dans une plage comprise entre 10kV et 100 kV

- Les inventeurs ont pu constater que selon la puissance (<400 W) et le diamètre (<100 mm) du faisceau, l'amélioration mécanique survenait dans une plage de vitesse de déplacement $V_D$ réduite comprise généralement entre 5 cm/s et 0,1 cm/s et qu'une optimisation était à ce titre souhaitable. Le procédé de l'invention préconise lors d'une étape préalable, l'ajustement de la vitesse de déplacement $V_D$ autour d'une **valeur nominale** dont la valeur dépend du diamètre et de la puissance du faisceau. Le procédé de l'invention propose une formule empirique (**voir plus bas**) permettant d'évaluer cette vitesse nominale en fonction de la puissance du faisceau et de son diamètre. La vitesse de déplacement $V_D$ doit être ajustée autour de cette valeur nominale, de préférence dans une plage de vitesse comprise entre la moitié de cette valeur nominale et deux fois cette valeur nominale, dans le but de réduire la taille des nanocavités et de répondre aux contraintes optiques (Y inférieure ou égale à 9%) et mécaniques (dureté de Mohs supérieure ou égale à 7) visées par l'invention. Cet ajustement de la vitesse de déplacement $V_D$ doit être effectué en maintenant constant les autres paramètres à savoir la dose, la tension d'accélération, le diamètre faisceau, le pas d'avancement, les amplitudes de déplacements définissant la zone de traitement.

- On ajuste les amplitudes de déplacement, lors d'une étape préalable de manière à supprimer autant que possible la mémoire thermique relative aux aller et retour du faisceau sur la pièce saphir. Une mémoire thermique aurait pour effet d'introduire des différences optiques et/ou mécaniques inacceptables selon l'emplacement des pièces saphir dans la zone de traitement. Pour s'en assurer, il suffit de placer des pièces saphir aux extrémités et au milieu de la zone de traitement délimitée par les amplitudes de déplacement et constater qu'il n'existe pas de différence optique et mécanique appréciables (notamment par l'œil humain) sur ces pièces après traitement. Si c'est le cas on peut augmenter les amplitudes de déplacement du faisceau et/ou arrêter momentanément le faisceau entre chaque aller-retour, pour laisser le temps aux pièces en saphir de refroidir avant un nouveau passage du faisceau. Le procédé de l'invention préconise de choisir l'amplitude de déplacement A du faisceau exprimée en cm de manière à ce que $(P/A^2) > 0,04$ W/$cm^2$ ou P est la puissance faisceau exprimée en W (Watt)

- On ajuste le pas d'avancement de manière à garantir l'homogénéité du traitement. On prend généralement des valeurs de pas d'avancement relatif inférieures ou égales à 20% du diamètre faisceau. Par exemple pour un pas d'avancement relatif de 15% et un diamètre faisceau de 40 mm, le pas d'avancement est égal à 6 mm. Remarque importante : si les amplitudes ne sont pas suffisamment grandes, un pas d'avancement trop petit peut induire une mémoire thermique du fait d'une série de passages trop nombreux du faisceau sur la pièce saphir. Pour atténuer cet effet, il convient d'augmenter l'amplitude et/ou augmenter le pas d'avancement tout en continuant de garantir l'homogénéité du traitement

L'implantation d'un mélange d'ions mono- et multichargés d'un gaz permet de répartir les ions sur une profondeur plus large que l'implantation d'ions portant une seule charge. Selon un mode de réalisation, le faisceau d'un mélange d'ions mono- et multichargés d'un gaz comprend 10% d'ions multichargés ou plus de 10% d'ions multichargés.

Selon un mode de réalisation, les ions mono- et multichargés d'un gaz du faisceau d'ions sont sélectionnés parmi les ions des éléments de la liste des gaz dits « nobles », constituée de l'hélium (He), du néon (Ne), de l'argon (Ar), du krypton(Kr) et du xénon (Xe).

Selon un autre mode de réalisation, les ions d'un gaz mono- et multichargés du faisceau d'ions sont sélectionnés parmi les ions des gaz de la liste constituée de l'azote ($N_2$) et l'oxygène ($O_2$).

Le choix de la dose d'ions d'un gaz mono- et multichargés par unité de surface dans la plage de dose selon l'invention peut résulter d'une étape préalable d'étalonnage où on bombarde avec un des ions d'un gaz mono-et multichargés, par exemple parmi He, Ne, Ar, Kr, Xe, $N_2$, $O_2$, un échantillon en saphir pour identifier la réflectance Y souhaitée. Pour une valeur de réflectance Y à 530 nm sensiblement comprise entre 9 et 7,2% les inventeurs préconisent pour des tensions d'extraction comprise entre 10 et 100 kV, des doses comprises préférentiellement entre $5 \times 10^{16}$ et $10^{17}$ ions/cm$^2$ pour des ions azote (N) et/ou oxygène (O). Cette plage de doses doit être revue à la hausse pour les ions hélium (He) et à la baisse pour les ions lourds argon, krypton et xénon de manière à tenir compte du libre parcours de ces ions dans la pièce saphir, plus long pour les ions légers et plus court pour les ions lourds. On peut calculer cette plage de dose de la manière suivante : pour un ion de masse atomique M, la plage de dose exprimée en ions/cm$^2$ est comprise entre $(5 \times 10^{16}) \times (M/14)^{-1/2}$ et $10^{17} \times (M/14)^{-1/2}$ pour avoir une réflectance Y située entre 7,2% et 9% et pouvoir adapter la vitesse de déplacement $V_D$ de manière à obtenir une dureté de Mohs supérieure ou égale à 7.

A titre d'exemple :

- Pour l'hélium (M=4) la plage de dose préférentielle est comprise entre $9,35 \times 10^{16}$ et $1,87 \times 10^{17}$ ions/cm$^2$

- Pour l'azote (M=14) la plage de dose préférentielle est comprise entre $5 \times 10^{16}$ et $10^{17}$ ions/cm$^2$

- Pour l'argon (M=40) la plage de dose préférentielle est comprise entre $3 \times 10^{16}$ et $6 \times 10^{16}$ ions/cm$^2$

La **vitesse nominale** V faisceau pour ajuster la vitesse de déplacement $V_D$ peut être déduite par la formule expérimentale suivante:

$$V = 0,05 \times (P/D) \text{ exprimée en cm/s}$$

Ou P est la puissance du faisceau exprimé en W (Watt) . $P = U \times I$ ou U et la tension d'accélération exprimée en kV (kilovolts) et I l'intensité faisceau exprimée en mA (milliAmpère). D le diamètre du faisceau exprimé en cm.

La plage d'exploration préférentielle de la vitesse de déplacement $V_D$ est comprise entre la moitié de cette vitesse nominale et 2 fois cette vitesse nominale soit une plage comprise entre $0,025 \times (P/D)$ et $0,1 \times (P/D)$. Au-dessus de la vitesse la plus grande (égale à $0,1 \times (P/D)$) la résistance mécanique n'est pas suffisante pour avoir une dureté de Mohs supérieure ou égale à 7, en deçà de la vitesse la plus faible (égale à $0,025 \times (P/D)$) la température dégrade la valeur de la transmittance.

A titre d'exemple, pour un faisceau de diamètre 8 cm, d'intensité 6 mA et de tension d'accélération égale à 27,5 kV on calcule par la formule du procédé de l'invention une vitesse nominale d'environ 1 cm/s. Pour 8 mA à 27,5 kV on trouve une vitesse nominale de 1,25 cm/s. Une fois cette vitesse nominale déduite, on peut pour une dose de traitement située dans la gamme de dose préférentielle (par exemple entre $5 \times 10^{16}$ et $10^{17}$ ions/cm$^2$ pour l'azote), ajuster la vitesse de déplacement $V_D$ (en l'augmentant ou en la réduisant) dans une plage de vitesse comprise préférentiellement entre 0,625 cm/s et 2,5 cm/s en vue d'obtenir dureté supérieure ou égale à 7 sur l'échelle de Mohs et une réflectance Y inférieure ou égale à 9%.

Les résultats ci-dessous illustrent le procédé de l'invention dans les conditions suivantes : traitement avec un faisceau d'un mélange d'ions mono- et multichargés d'azote de diamètre 40 mm, d'intensité égale 1,5 mA, une tension de 25 kV, un pas d'avancement de 15%, selon trois vitesses de déplacement $V_D$, la première vitesse égale à 80 mm/s très largement supérieure à la vitesse nominale (égale à 0,5 cm/s) la seconde à 10 mm/s proche de la vitesse nominale, enfin la troisième égale 0,5 cm/s autrement dit égale à la vitesse nominale.

Dans la description de la présente invention, on trouvera des résultats associés à des pièces en saphir traitées sur un porte pièce refroidi avec de l'eau à la température ambiante (environs 20°C). Selon un autre mode de réalisation de l'invention, les pièces en saphir peuvent être traitées sur un porte pièce porté à une température plus élevée, de préférence n'excédant pas 150°C, à condition d'augmenter la vitesse de déplacement $V_D$ pour éviter un échauffement excessif des pièces en saphir durant le traitement. Celui-ci aurait pour effet de dégrader les propriétés anti-réflectives recherchées

Pour tous les exemples le substrat est un matériau saphir de dimensions 12 cm x 6 cm et d'épaisseur 1 mm. Le traitement antireflet est effectué sur une seule/les deux face(s) du substrat.

| | Exemple 1 | Exemple 2 | Exemple 3 |
|---|---|---|---|
| **Puissance (W)** | 37,5 | 37,5 | 37,5 |

(suite)

|  | Exemple 1 | Exemple 2 | Exemple 3 |
|---|---|---|---|
| **Diamètre du faisceau** | 40 mm | 40 mm | 40 mm |
| **Dose (x $10^{16}$ ions/cm$^2$)** | 8 | 8 | 8 |
| **Vitesse $V_D$ (cm/s)** | 8 | 1 | 0,5 |
| **Dureté Mohs** | 6 | 7 | $\geq$**7** |
| **Y (%) à 530 nm** | 8, 92 | **8,51** | **8,27** |

On constate une nette amélioration du comportement mécanique lorsqu'on réduit la vitesse de déplacement $V_D$ aux alentours de la vitesse nominale estimé à 0,5 cm/s : la dureté de Mohs est égale à 6 pour 80 mm/s et augmente jusqu'à atteindre 7 pour 10 mm/s voire supérieure à 7 pour une vitesse égale à la vitesse nominale.

On constate également que la dose 8 x $10^{16}$ ions/cm$^2$ avec une vitesse de déplacement faisceau variant entre 0,5 et 1 cm/s répond aux critères satisfaisants à une haute transmittance (Y $\leq$ 9%) et une dureté de Mohs supérieure ou égale à 7.

Des analyses TEM (Microscopie Electronique en Transmission) de l'épaisseur traitée ont permis de comprendre les différences de comportement mécaniques obtenues par le procédé de l'invention entre l'échantillon traité à 8 cm/s et celui traité à 1 cm/s.

Le profil de distribution de l'azote dans ces deux échantillons a été déterminé par profilage SIMS (Secondary Ion Mass Spectrometry) en mode dynamique. L'équipement utilisé est un appareil Cameca imsf-4. Les conditions de sputtering sont : faisceau primaire 5,5 KeV Cs+, densité de courant 0,16 mA/cm$^2$, aire pulvérisée 125 x 125 $\mu$m$^2$. La surface analysée a un diamètre de 60 $\mu$m. Les ions MCs+ sont détectés, M étant l'élément à analyser. Pour chaque élément M, l'intensité du signal MCs+ en fonction du temps de pulvérisation est détectée de telle sorte que la variation de la concentration de chaque élément suivi est obtenue en fonction du temps de pulvérisation. L'échelle de temps de pulvérisation peut être convertie en échelle de profondeur pour autant que la vitesse de pulvérisation soit constante et dans le cadre de la présente invention on considère que c'est le cas. Les intensités des ions détectés sont normalisées par rapport au rapport isotopique de l'élément et à l'intensité de l'ion Cs+.

Pour chaque échantillon, l'intégrale du rapport d'intensité I(NCs$^+$)/I(AlCs$^+$) en fonction de la profondeur est calculée. Les valeurs relatives de la quantité d'azote implanté sont obtenues en soustrayant la valeur de l'intégrale I(NCs$^+$)/I(AlCs$^+$) d'un échantillon non traité de la valeur de l'intégrale du rapport d'intensité I(NCs$^+$)/I(AlCs$^+$) d'un échantillon traité. La profondeur d'implantation D d'un échantillon traité est la profondeur à laquelle le rapport d'intensité I(NCs$^+$)/I(AlCs$^+$) est égal à la valeur de référence.

Le descriptif de la mesure de la taille des nanocavités: La structure en dessous de la surface des échantillons traités est déterminée par Microscopie Electronique à Transmission (TEM). A cet effet, une coupe transversale est réalisée dans la surface de l'échantillon à l'aide de la technique FIB (Focused Ion Beam). Durant la préparation, une mince couche conductrice de carbone et une couche de Pt sont déposées à la surface de l'échantillon. Les coupes ainsi réalisées sont polies par faisceau ionique puis analysées par microscopie électronique à transmission en mode « Bright Field » (BF TEM) et en mode « High Angle Annular Dark Field » (HAADF TEM) sur un équipement de marque FEI Tecnai Osiris opérant à 200 kV. Les images ainsi obtenues, présentent une structure poreuse et montrent des coupes transversales à travers des nanocavités. Ces images sont traitées en utilisant le logiciel ImageJ (développé par le National Institute of Health, USA). Dans le cadre de la présente invention, la taille d'une nanocavité correspond au diamètre circulaire équivalent de la coupe transversale de cette nanocavité représentée sur l'image que l'on obtient par la méthode décrite ci-dessus. Le diamètre circulaire équivalent de la section transversale d'une nanocavité, ayant le plus souvent une forme irrégulière, est le diamètre d'un disque bidimensionnel ayant une aire équivalente à la section transversale de cette nanocavité, comme déterminé par ce procédé de traitement d'image. La taille moyenne des nanocavités d'une zone poreuse est la moyenne arithmétique des tailles des nanocavités observées dans cette zone. On appelle porosité d'une zone poreuse, le pourcentage de la surface de la section transversale de cette zone poreuse qui est occupée par des pores, telle qu'évaluée par le procédé de traitement d'image détaillé ci-dessus.

Pour l'échantillon traité à 8 cm/s (exemple 1), la couche implantée de la pièce de saphir comporte en partant de la surface de la pièce vers l'intérieur de la pièce :

• une couche compacte, c'est-à-dire sans porosité détectable par la méthode utilisée, de 7 nm d'épaisseur ;

• une couche amorphe poreuse de 50 nm d'épaisseur avec des pores (nanocavités) d'une taille moyenne de 20 nm avec un écart type de 6 nm autour de cette moyenne. 50% des pores ont une taille inférieure à 18 nm, 75% des pores ont une taille inférieure à 24 nm. La porosité est de 50%;

- une couche amorphe sans pores, c'est-à-dire sans porosité détectable par la méthode utilisée, de 30 nm d'épaisseur ;
  Par la méthode utilisée on ne détecte pas de pore de taille inférieure à 3nm ;

- une couche à cristallinité altérée de 60 nm d'épaisseur ; une telle couche est cristalline mais sa cristallinité est différente de celle du saphir avant le traitement

- du saphir non-altéré.

Le profil de distribution de l'azote dans cet échantillon montre que l'intégrale du rapport d'intensité I(NCs+)/I(AlCs+) est de 1,66 +/- 0,03.

Pour l'échantillon traité à 1 cm/s (exemple 2) la couche implantée (dans les conditions du procédé de l'invention) comporte de la surface de la pièce vers l'intérieur:

- une couche compacte de 7 à 10 nm d'épaisseur ;

- une couche amorphe poreuse de 60 nm d'épaisseur, de porosité 26% avec des pores (nanocavités) d'une taille moyenne égale à 11 nm et écart type de 4 nm autour de cette moyenne. 50% des pores ont une taille inférieure à 10nm, 75% des pores ont une taille inférieure à 13 nm.;

- une couche amorphe sans pores visibles de 20 nm d'épaisseur ;

- une couche à cristallinité altérée de 50 nm d'épaisseur ;

- du saphir non-altéré.

Le profil de distribution de l'azote dans cet échantillon montre que l'intégrale du rapport d'intensité I(NCs+)/I(AlCs+) est de 1,67 +/- 0,03.

La couche compacte et la couche amorphe poreuse sont en plus grande partie à la base des propriétés de durabilité et de réflectance observées.

Les conditions thermiques induites grâce aux conditions du procédé de l'invention à une vitesse de déplacement $V_D$ de 10 mm/s permettent de créer des pores (nanocavités) de plus petites tailles comparativement à ceux crées sans effet de température à 80 mm/s. **Pour obtenir des propriétés mécaniques satisfaisantes (dureté de Mohs $\geq$ 7) le procédé de l'invention préconise des tailles moyennes de nanocavités qui n'excèdent pas 15 nm dans une profondeur de traitement comprise entre 5 et 70 nm.** En réduisant la taille des pores, on augmente la superficie des parois des pores et on améliore les caractéristiques mécaniques du saphir implanté..

Sans vouloir être lié par une quelconque théorie scientifique, on peut penser qu'en s'appuyant sur l'exemple 1 précédent, pour une vitesse de déplacement $V_D$ de 8 cm/s (l'échauffement n'est pas suffisant compte tenu de la grande vitesse de déplacement $V_D$, les lacunes et les interstitiels induites par l'implantation ne bougent quasiment pas durant le traitement, mais finissent par percoler puis s'effondrer sous forme de grosses nanocavités d'une taille moyenne de 20 nm dès qu'on dépasse un seuil de concentration atomique d'ions implantés estimé autour de 5% (seuil de percolation).

Si on réduit la vitesse de déplacement $V_D$ à 1 cm/s (dans les conditions du procédé de l'invention, voir exemple 2), on crée un échauffement local suffisant pour favoriser la mobilité et les rencontres des lacunes, le déplacement des ions gazeux implantés en tant qu'interstitiel, bien avant d'atteindre le seuil de percolation estimé à 5%. Les lacunes se rencontrent pour créer des dislocations qui se transforment à leur tour en une multitudes de nanocavités très bien dispersées, piégeant à leur tour les ions gazeux implantés.

Si on réduit encore plus la vitesse de déplacement $V_D$ par exemple en deçà de 1 mm/s, l'effet thermique devient trop fort, on assiste à une dégradation de la réflectance (Y>9%) relative à la diffusion des espèces implantées, à la réduction de la taille des nanocavités voire à leur disparition.

Le procédé de l'invention consiste en un réglage précis, en dose et en vitesse de déplacement $V_D$, pour concilier les deux facettes du problème : des propriétés optiques acceptables (Y $\leq$ 9%) et des propriétés mécaniques nécessaires (dureté de Mohs$\geq$7). Les conditions de mise en œuvre de l'invention se traduisent par la production dans l'épaisseur traitée d'une zone de nanocavités dont la taille moyenne est inférieure à 15 nm.

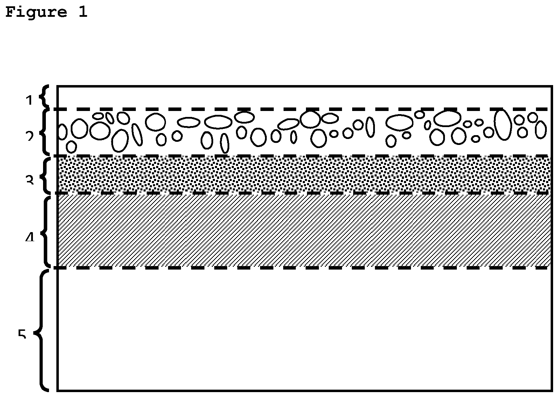

- la figure 1 montre schématiquement la structure d'un traitement AR obtenu selon le procédé de l'invention en partant de la surface dans le sens de la profondeur :

- Une couche compacte (1) de d'une épaisseur comprise entre 5 et 10 nm ;

- Une couche amorphe poreuse (2) d'une épaisseur comprise entre 50 et 60 nm, de porosité comprise entre 10 et 60%, avec des pores (nanocavités) d'une taille moyenne :

  o supérieure ou égale à 15 nm lorsque dureté de Mohs< 7

  o à 15 nm, de préférence comprise entre 3 et 15 nm, plus préférentiellement entre 8 et 12 nm lorsque dureté de Mohs≥7,

- D'une couche amorphe (3) sans pores d'une épaisseur comprise entre 20 à 30 nm ;

- D'une couche à cristallinité altérée (4) d'une épaisseur comprise entre 50 à 60 nm ;

- De saphir non-altéré au-delà d'une profondeur située entre 125 et 160 nm ;

La taille moyenne des nanocavités de la couche amorphe poreuse est

- supérieure ou égale à 15 nm lorsque dureté de Mohs < 7 ;

- inférieure à 15 nm lorsque dureté de Mohs ≥ 7 ; préférentiellement comprise entre 1 et 15 nm, plus préférentiellement comprise entre 5 et 10 nm.

Pour une dose d'ions d'azote comprise entre 0,5 et $10^{17}$ ions/cm2, le procédé de l'invention permet de créées des conditions thermiques locales et transitoire permettant d'initier avant le seuil de percolation (situé autour de 5%) des nanocavités d'une taille moyenne (<15 nm) très bien dispersées garantissant de bonnes propriétés mécaniques (dureté de Mohs ≥7) et une haute transmittance (Y ≤ 9%).

**Revendications**

1. Procédé de traitement antireflet dans le domaine visible d'un matériau en saphir consistant en un bombardement par faisceau d'un mélange d'ions mono- et multichargés d'un gaz produits par une source à résonance cyclotronique électronique (RCE) où :

   - on choisit la tension d'accélération dans une plage comprise entre 10 et 100 kV ;
   - on choisit une dose d'ions implantée exprimée en ions/cm$^2$ dans une plage comprise entre $10^{16}$ et $3 \times 10^{17}$ ions/cm$^2$; **caractérisé en ce que**

   l'on choisit une vitesse de déplacement $V_D$ entre le matériau en saphir et le faisceau exprimée en cm/s dans une plage comprise entre 0,1 cm/s et 5 cm/s, la vitesse de déplacement $V_D$ étant ajustée de sorte qu'elle soit comprise entre 0,025 x (P/D) et 0,1 x (P/D) où P est la puissance du faisceau exprimée en W (Watt), D le diamètre du faisceau exprimé en cm (centimètre);l'ajustement étant effectué en maintenant constants la tension d'accélération, la dose d'ions implantés, le diamètre du faisceau, les amplitudes de déplacement du faisceau et le pas d'avancement du faisceau.

2. Procédé selon la revendication 1 **caractérisé en ce que** les ions mono- et multichargés d'un gaz du faisceau d'un mélange d'ions mono- et multichargés sont sélectionnés parmi les ions des éléments de la liste constituée de l'hélium (He), du néon (Ne), de l'argon (Ar), du krypton (Kr), du xénon (Xe).

3. Procédé selon la revendication 1 **caractérisé en ce que** les ions mono- et multichargés d'un gaz du faisceau d'un mélange d'ions mono- et multichargés sont sélectionnés parmi les ions des gaz de la liste constituée de l'azote ($N_2$) et l'oxygène ($O_2$).

4. Procédé selon l'une quelconque des revendications précédentes **caractérisé en ce que** la dose implantée exprimée en ions/cm$^2$ est comprise entre (5 x $10^{16}$) x $(M/14)^{-1/2}$ et $10^{17}$ x $(M/14)^{-1/2}$ ou M est la masse atomique de l'ion.

5. Procédé selon l'une quelconques de revendications précédentes **caractérisé en ce que** l'on choisit une amplitude de déplacement A du faisceau exprimée en cm de manière à ce que (P/A$^2$) >0,04 W/cm$^2$ ou P est la puissance faisceau exprimée en W (Watt).

6. Procédé selon l'une quelconque des revendications précédentes **caractérisé en ce que** le faisceau d'un mélange d'ions mono- et multichargés d'un gaz comprend 10% d'ions multichargés ou plus de 10% d'ions multichargés.

7. Procédé selon l'une quelconque des revendications précédentes **caractérisé en ce que** la dose d'ions d'un gaz mono- et multichargés implantés par unité de surface est choisie pour atteindre une concentration atomique en ions implantés supérieure ou égal à 5%.

8. Procédé selon l'une quelconque des revendications précédentes **caractérisé en ce que** la vitesse de déplacement $V_D$ est choisie pour obtenir dans l'épaisseur traitée des nanocavités dont la taille moyenne n'excède pas 15 nm dans une profondeur comprise entre 5 et 70 nm.

9. Procédé selon la revendication précédente **caractérisé en ce que** le matériau en saphir est déplacée sous le faisceau d'un mélange d'ions mono- et multichargés d'un gaz selon une pluralité, N, de passages à la vitesse $V_D$.

10. Pièce en saphir comprenant au moins une surface avec un ion implanté selon l'une quelconque des revendications précédente, **caractérisée en ce que** la réflectance Y d'une seule face traitée est inférieure ou égale à 9% pour une longueur d'onde de 530 nm et **en ce que** la dureté de Mohs est supérieure ou égale à 7 sur l'échelle de Mohs.

11. Pièce en saphir selon la revendication 10, **caractérisé en ce que** la taille moyenne des nanocavités créées dans une profondeur comprise entre 5 et 70 nm n'excède pas 15 nm.

12. Pièce en saphir selon la revendication 10 ou 11, comprenant en partant de ladite surface dans le sens de la profondeur :

   • Une couche compacte (1) non poreuse d'une épaisseur comprise entre 5 et 10 nm ;
   • Une couche amorphe poreuse (2) dont le pourcentage de la surface de la section transversale occupée par des pores est comprise entre 10 et 60%, d'une épaisseur comprise entre 50 et 60 nm avec des nanocavités ayant une taille moyenne inférieure à 15 nm.

13. Utilisation du procédé de traitement selon l'une quelconque des revendications 1 à 9 pour traiter une pièce en saphir choisie parmi la liste constituée d'un écran tactile, d'un verre de montre, d'une lentille d'un dispositif optique.

**Patentansprüche**

1. Verfahren zur Entspiegelungsbearbeitung eines Saphirmaterials im sichtbaren Bereich, umfassend einen Strahlenbeschuss mit einer Mischung von ein- und mehrfach geladenen Ionen eines Gases, erzeugt von einer Elektronenzyklotron-Resonanzquelle (ECR), wobei

   - die Beschleunigungsspannung in einem Bereich zwischen 10 und 100 kV gewählt wird;
   - eine in Ionen/cm$^2$ angegebene implantierte Ionendosis in einem Bereich zwischen $10^{16}$ und $3 \times 10^{17}$ Ionen/cm$^2$ gewählt wird; **dadurch gekennzeichnet, dass** eine in cm/s angegebene Verlagerungsgeschwindigkeit $V_D$ zwischen dem Saphirmaterial und dem Strahl in einem Bereich zwischen 0,1 cm/s und 5 cm/s gewählt wird, wobei die Verlagerungsgeschwindigkeit $V_D$ derart angepasst wird, dass sie zwischen 0,025 x (P/D) und 0,1 x (P/D) liegt, wobei P die in W (Watt) angegebene Leistung des Strahls ist und D der in cm (Zentimeter) angegebene Durchmesser des Strahls ist; wobei die Anpassung durch Konstanthalten der Beschleunigungsspannung, der Dosis der implantierten Ionen, des Strahldurchmessers, der Strahlverlagerungsamplituden und des Strahlvorschubabstands erfolgt.

2. Verfahren nach Anspruch 1, **dadurch gekennzeichnet, dass** die ein- und mehrfach geladenen Ionen eines Gases des Strahls aus einer Mischung von ein- und mehrfach geladenen Ionen aus den Ionen der Elemente der Liste gewählt werden, umfassend Helium (He), Neon (Ne), Argon (Ar), Krypton (Kr) und Xenon (Xe).

3. Verfahren nach Anspruch 1, **dadurch gekennzeichnet, dass** die ein- und mehrfach geladenen Ionen eines Gases des Strahls einer Mischung von ein- und mehrfach geladenen Ionen aus den Ionen der Gase der Liste gewählt

werden, umfassend Stickstoff ($N_2$) und Sauerstoff ($O_2$).

4. Verfahren nach einem der vorhergehenden Ansprüche, **dadurch gekennzeichnet, dass** die in Ionen/cm$^2$ angegebene implantierte Dosis zwischen ($5 \times 10^{16}$) x $(M/14)^{-1/2}$ und $10^{17}$ x $(M/14)^{-1/2}$ liegt, wobei M die Atommasse des Ions ist.

5. Verfahren nach einem der vorhergehenden Ansprüche, **dadurch gekennzeichnet, dass** eine in cm angegebene Amplitude der Verlagerung A des Strahls derart gewählt wird, dass $(P/A^2) > 0{,}04$ W/cm$^2$ ist, wobei P die in W (Watt) angegebene Strahlleistung ist.

6. Verfahren nach einem der vorhergehenden Ansprüche, **dadurch gekennzeichnet, dass** der Strahl einer Mischung von ein- und mehrfach geladenen Ionen eines Gases 10% mehrfach geladene Ionen oder mehr als 10% mehrfach geladene Ionen umfasst.

7. Verfahren nach einer der vorhergehenden Ansprüche, **dadurch gekennzeichnet, dass** die Dosis von pro Flächeneinheit implantierten ein- und mehrfach geladenen Ionen eines Gases derart gewählt wird, dass eine Atomkonzentration von implantierten Ionen größer oder gleich 5% erreicht wird.

8. Verfahren nach einem der vorhergehenden Ansprüche, **dadurch gekennzeichnet, dass** die Verlagerungsgeschwindigkeit $V_D$ derart gewählt wird, dass in der behandelten Dicke Nanokavitäten erhalten werden, deren mittlere Größe 15 nm in einer Tiefe zwischen 5 und 70 nm nicht überschreitet.

9. Verfahren nach dem vorhergehenden Anspruch, **dadurch gekennzeichnet, dass** das Saphirmaterial unter dem Strahl einer Mischung von ein- und mehrfach geladenen Ionen eines Gases mit einer Vielzahl N von Durchgängen mit der Geschwindigkeit $V_D$ verlagert wird.

10. Saphir-Werkstück, welches mindestens eine Oberfläche mit einem nach einem der vorhergehenden Ansprüche implantierten Ion umfasst, **dadurch gekennzeichnet, dass** der Reflexionsgrad Y einer einzigen behandelten Fläche kleiner oder gleich 9 % für eine Wellenlänge von 530 nm ist und dass die Mohs-Härte größer oder gleich 7 auf der Mohs-Skala ist.

11. Saphir-Werkstück nach Anspruch 10, **dadurch gekennzeichnet, dass** die mittlere Größe der in einer Tiefe zwischen 5 und 70 nm erzeugten Nanokavitäten 15 nm nicht überschreitet.

12. Saphir-Werkstück nach Anspruch 10 oder 11, umfassend, ausgehend von der genannten Oberfläche in Richtung der Tiefe:

   • eine kompakte nicht poröse Schicht (1) mit einer Dicke zwischen 5 und 10 nm;
   • eine poröse amorphe Schicht (2) mit einem Prozentsatz der von Poren eingenommenen Querschnittsfläche zwischen 10 und 60%, mit einer Dicke zwischen 50 und 60 nm mit Nanokavitäten mit einer mittleren Größe von weniger als 15 nm.

13. Verwendung des Bearbeitungsverfahrens nach einem der Ansprüche 1 bis 9 zur Bearbeitung eines Saphir-Werkstücks, gewählt aus der Liste, umfassend einen Berührungsbildschirm, ein Uhrglas, eine Linse einer optischen Vorrichtung.


**Claims**

1. Process for antireflective treatment in the visible region of a material made of sapphire, consisting of a bombardment with a beam of a mixture of mono- and multicharged ions of a gas which are produced by an electron cyclotron resonance (ECR) source, wherein:

   - the acceleration voltage is chosen within a range of between 10 and 100 kV;
   - an implanted dose of ions, expressed in ions/cm$^2$, is chosen within a range of between $10^{16}$ and $3 \times 10^{17}$ ions/cm$^2$; **characterized in that**

   a rate of displacement $V_D$ between the material made of sapphire and the beam, expressed in cm/s, is chosen within a range of between 0.1 cm/s and 5 cm/s, the rate of displacement $V_D$ is adjusted so that it is between 0.025 x (P/D) and 0.1 x (P/D), where P is the power of the beam, expressed in W (watts), D is the diameter of the beam, expressed in cm (centimetres); the adjustment being carried out while keeping the acceleration voltage, the implanted dose of ions, the beam diameter, the displacement amplitude of the beam and the advance amplitude of the beam constant.

2. Process according to Claim 1, **characterized in that** the mono- and multicharged ions of a gas of the beam of a mixture of mono- and multicharged ions are selected from the ions of the elements of the list consisting of helium (He), neon (Ne), argon (Ar), krypton (Kr) and xenon (Xe).

3. Process according to Claim 1, **characterized in that** the mono- and multicharged ions of a gas of the beam of a mixture of mono- and multicharged ions are selected from the ions of the gases of the list consisting of nitrogen ($N_2$) and oxygen ($O_2$).

4. Process according to any one of the preceding claims, **characterized in that** the implanted dose, expressed in ions/cm$^2$, is between $(5 \times 10^{16}) \times (M/14)^{-1/2}$ and $10^{17} \times (M/14)^{-1/2}$, where M is the atomic mass of the ion.

5. The process according to any one of the preceding claims, **characterized in that** the displacement amplitude A of the beam, expressed in cm, is chosen so that $(P/A^2) > 0.04$ W/cm$^2$, where P is the power of the beam, expressed in W (watts) .

6. Process according to any one of the preceding claims, **characterized in that** the beam of a mixture of mono- and multicharged ions of a gas comprises 10% of multicharged ions or more than 10% of multicharged ions.

7. Process according to any one of the preceding claims, **characterized in that** the dose of mono- and multicharged ions of a gas which are implanted per unit of surface area is chosen in order to achieve an atomic concentration of implanted ions of greater than or equal to 5%.

8. Process according to any one of the preceding claims, **characterized in that** the rate of displacement $V_D$ is chosen in order to obtain, in the treated thickness, nanocavities for which the mean size does not exceed 15 nm in a depth of between 5 and 70 nm.

9. Process according to the preceding claim, **characterized in that** the part made of sapphire is displaced under the beam of a mixture of mono- and multicharged ions of a gas according to a plurality N of passes at the rate $V_D$.

10. Part made of sapphire comprising at least one surface with an implanted ion according to any one of the preceding claims, **characterized in that** the reflectance Y of one single treated face is less than or equal to 9% for a wavelength of 530 nm and **in that** the Mohs hardness is greater than or equal to 7 on the Mohs scale.

11. Part made of sapphire of claim 10, **characterized in that** the mean size of the nanocavities created in a depth of between 5 and 70 nm does not exceed 15 nm.

12. Part made of sapphire of claim 10 or 11, comprising, starting from the surface in the direction of the depth:

   • a compact layer (1) with a thickness of between 5 and 10 nm;
   • a porous amorphous layer (2) with a porosity of between 10% and 60%, with a thickness of between 50 and 60 nm, with nanocavities having a mean size of less than 15 nm.

13. Use of the treatment process according to any one of Claims 1 to 9 for treating a part made of sapphire chosen from the list consisting of a touch screen, of a watch glass or of a lens of an optical device.

Figure 1

## RÉFÉRENCES CITÉES DANS LA DESCRIPTION

**Documents brevets cités dans la description**

- WO 2015176850 A1

- FR 3027120